(19) Europäisches Patentamt
European Patent Office
Office européen des brevets

(11) **EP 3 199 929 B1**

(12) **EUROPÄISCHE PATENTSCHRIFT**

(45) Veröffentlichungstag und Bekanntmachung des Hinweises auf die Patenterteilung:
**17.04.2019   Patentblatt 2019/16**

(51) Int Cl.:
*G01K 7/16* (2006.01)        *G01K 7/34* (2006.01)
*G01K 3/12* (2006.01)        *H02M 5/458* (2006.01)

(21) Anmeldenummer: **17152999.3**

(22) Anmeldetag: **25.01.2017**

(54) **VERFAHREN UND VORRICHTUNG ZUM ERMITTELN EINES TEMPERATURVERLAUFS EINES ZWISCHENKREISKONDENSATORS EINES ZWISCHENKREISUMRICHTERS**

METHOD AND DEVICE TO MEASURE TEMPERATURE OF AN INTERMEDIATE CIRCUIT CAPACITOR

METHODE ET DISPOSITIF DE MESURE DE TEMPÉRATURE D'UN CONDENSATEUR À CIRCUIT INTERMÉDIAIRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **29.01.2016   AT 500482016**

(43) Veröffentlichungstag der Anmeldung:
**02.08.2017   Patentblatt 2017/31**

(73) Patentinhaber: **B&R Industrial Automation GmbH 5142 Eggelsberg (AT)**

(72) Erfinder:
• **Doppelhammer, Klaus 4113 St. Martin/i.M. (AT)**
• **Eder, Johann 5152 Michaelbeuern (AT)**
• **Mayrhofer-Huber, Gerhard 4880 St. Georgen im Attergau (AT)**

(74) Vertreter: **Patentanwälte Pinter & Weiss OG Prinz-Eugen-Straße 70 1040 Wien (AT)**

(56) Entgegenhaltungen:
**EP-A1- 2 637 030     DE-A1-102013 203 299**

• **MADDULA ET AL: "Lifetime of Electrolytic Capacitors in Regenerative Induction Motor Drives", POWER ELECTRONICS SPECIALISTS CONFERENCE, 2005. PESC '05. IEEE 36TH, IEEE, PISCATAWAY, NJ, USA, 1. Januar 2005 (2005-01-01), Seiten 153-159, XP031000172, DOI: 10.1109/PESC.2005.1581617 ISBN: 978-0-7803-9033-1**
• **AELOIZA ET AL: "A Real Time Method to Estimate Electrolytic Capacitor Condition in PWM Adjustable Speed Drives and Uninterruptible Power Supplies", POWER ELECTRONICS SPECIALISTS CONFERENCE, 2005. PESC '05. IEEE 36TH, IEEE, PISCATAWAY, NJ, USA, 1. Januar 2005 (2005-01-01), Seiten 2867-2872, XP031000530, DOI: 10.1109/PESC.2005.1582040 ISBN: 978-0-7803-9033-1**

**Beschreibung**

Die gegenständliche Erfindung betrifft ein Verfahren und eine Vorrichtung zum Ermitteln eines Temperaturverlaufs eines Zwischenkreiskondensators eines Zwischenkreisumrichters, der mindestens einen n-phasigen Wechselrichter beinhaltet, wobei der Zwischenkreiskondensator als Serienschaltung einer Ersatzkapazität und eines Ersatzserienwiderstands modelliert wird. Weiters wird die Verwendung der erfindungsgemäßen Verfahren zur Ermittlung der Restlebensdauer des Zwischenkreiskondensators aus dem Temperaturverlauf beschrieben.

Zwischenkreisumrichter werden in einer Vielzahl von Schaltungen verwendet, darunter Servoverstärker, Frequenzumrichter, Konverter, Ein-/Rückspeiser, usw., insbesondere für Elektromotorantriebe, beispielsweise Schrittmotoren oder bürstenlose Gleichstrommotoren, etc. Dabei werden oftmals Kondensatoren und im Speziellen Elektrolytkondensatoren (ELKOs) in Zwischenkreisen als energiespeichernde Elemente verbaut, wobei diese Zwischenkreiskondensatoren dazu dienen, die Zwischenkreisspannung zu glätten. Durch eine gewünschte Platzeinsparung können in manchen Systemen nur noch eine limitierte Anzahl an solchen Kondensatoren verbaut werden. Dabei ist die Lebensdauer der Gesamtschaltung oder von Schaltungsteilen oftmals in erster Linie von der Lebensdauer des Kondensators des Zwischenkreises abhängig. Da es bei hohen Leistungsanforderungen zu thermischen Problemen der Zwischenkreiskondensatoren kommen kann, ist es von Vorteil, wenn die Restlebensdauer des Zwischenkreisondensators bekannt ist. Die Kondensatorlebensdauer wiederum kann dabei in bekannter Weise mittels der Arrhenius-Formel aus einem zeitlichen Temperaturverlauf des Kondensators ermittelt werden. Hierzu werden oftmals die Umgebungstemperatur und/oder die Rippelstrombelastung des Kondensators herangezogen. Eine Eruierung der Kondensatorlebensdauer ist somit meist nur im Labor möglich, da nur hier fest vorgegebene Umstände (Umgebungstemperatur, Stromverlauf, etc.) geschaffen werden können. Diese Methode wird oftmals zur a priori Auslegung und Optimierung von Kondensatoren verwendet. Bei bekannten Anforderungen können dann Kondensatoren mit gewünschten Eigenschaften verwendet werden.

Es ist jedoch, vor Allem bei zuvor nicht bekannten Anforderungen, oftmals wünschenswert, dass die (Rest)Lebensdauer eines Kondensators auch im laufenden Betrieb, und insbesondere in einem Zwischenkreisumrichter verbaut, vorhergesagt bzw. bestimmt werden kann. Die KR 2013 0110553 A bietet einen derartigen Ansatz, wobei in der Druckschrift der Umrichter einen Elektromotor versorgt. Ausgehend vom Drehmoment des Elektromotors und der Winkelgeschwindigkeit des zugehörigen Rotors wird die elektrische Gesamtleistung der Umrichterschaltung berechnet. Ausgehend von der am Zwischenkreiskondensator anliegenden Spannung und der ermittelten Gesamtleistung wird in weiterer Folge der Rippelstrom abgeschätzt. Anschließend wird aus dem Verlauf des abgeschätzten Rippelstroms anhand von gespeicherten Kennlinien der Verlauf der Temperatur des Zwischenkreiskondensators und in weiterer Folge die Lebensdauer des Zwischenkreiskondensators ermittelt. Nachteilig ist hierbei, dass die ermittelte Gesamtleistung des Umrichters nicht der am Zwischenkreiskondensator verbrauchten Leistung entspricht und daher in weiterer Folge der abgeschätzte Rippelstrom nicht tatsächlich mit dem Strom durch den Zwischenkreiskondensator übereinstimmt. Damit ist auch der ermittelte Temperaturverlauf sehr ungenau. Weiters sind zusätzliche Sensoren zur Ermittlung des Drehmoments und der Geschwindigkeit erforderlich.

Man könnte den Kondensatorstrom und die Kondensatorspannung oder die am Zwischenkreiskondensator verbrauchte Leistung oder auch die Kondensatortemperatur messtechnisch ermitteln. Die gesamte dafür benötigte zusätzliche Messtechnik ist aber in einem Zwischenkreisumrichter häufig aus Kosten- und Platzgründen unerwünscht. Insbesondere die Messung der Kondensatortemperatur (also die Temperatur im Inneren des Zwischenkreiskondensators) würde spezielle, mit integrierten Temperatursensoren ausgestatte und damit teure, Zwischenkreiskondensatoren erfordern. Maddula et.al.: "Lifetime of Electrolytic Capacitors in Regenerative Induction Motor Drives", Power Electronics Specialists Conference, 2005, PESC '05. IEEE 36th, Seiten 153-159 offenbart beispielweise einen Zwischenkreiskondensator, welcher als Serienschaltung einer Ersatzkapazität und eines Ersatzserienwiderstands modelliert wird. Es wird ein Kondensatorstrom ermittelt, daraus eine Leistung und weiter eine Kondensatortemperatur berechnet.

Ziel der Erfindung ist es somit die Temperatur eines Zwischenkreiskondensators in einer Zwischenkreisumrichterschaltung mit geringerem Aufwand genauer zu ermitteln, wobei insbesondere auch die oben genannten Nachteile vermieden werden sollen.

Dieses Ziel wird erreicht über den Ersatzserienwiderstand ein modellierter Kondensatorstrom fließt,. aus dem modellierten Kondensatorstrom und dem Wert des Ersatzserienwiderstands mittels eines ersten Zusammenhangs der Form $P_C = f(i_{Cm}, ESR)$ eine modellierte Kondensatorverlustleistung berechnet und aus der mittels eines vorgegebenen Temperaturmodells die Kondensatortemperatur ermittelt wird.

Die modellierte Kondensatorverlustleistung fällt im Kondensatormodell mit der Ersatzkapazität und dem Serienwiderstand am Serienwiderstand ab. Es wird also der durch den Serienwiderstand und damit durch den Zwischenkreiskondensator fließende Kondensatorstrom selbst modelliert und davon ausgehend die modellierte Kondensatorverlustleistung am Zwischenkreiskondensator berechnet. Davon ausgehend kann über ein bekanntes Temperaturmodell, beispielsweise ein PT1-Modell, die Kondensatortemperatur ermittelt werden.

Zur erfindungsgemäßen Berechnung der Kondensatortemperatur kann eine Berechnungseinheit vorgesehen sein.

Vorteilhafterweise wird als erster Zusammenhang $P_C = i_{Cm}^2 \, ESR$ verwendet.

Der modellierte Kondensatorstrom kann unter Verwendung einer gemessenen Kondensatorspannung und der Ersatzkapazität CS modelliert werden, wobei ein zweiter Zusammenhang der Form $i_{Cm} = f(u_C, CS)$ verwendet wird.

Vorteilhafterweise wird als zweiter Zusammenhang $i_{Cm} = CS \frac{d}{dt} u_C \, i_{Cm}$ verwendet.

Zu diesem Zweck können eine Spannungsmesseinheit und eine Differenziereinheit vorhanden sind, wobei die Spannungsmesseinheit eine am Zwischenkreiskondensator anliegende Kondensatorspannung ermittelt und der Differenziereinheit zuführt und die Differenziereinheit den modellierten Kondensatorstrom nach Multiplikation mit der Ersatzkapazität ermittelt.

Vorteilhafterweise wird der modellierte Kondensatorstrom in einen niederfrequenten Anteil und einen hochfrequenten Anteil aufgeteilt, wobei der niederfrequente Anteil des modellierten Kondensatorstroms zur Ermittlung einer ersten modellierten Verlustleistung und der hochfrequente Anteil des modellierten Kondensatorstroms zur Ermittlung einer zweiten modellierten Verlustleistung herangezogen wird. Die modellierte Kondensatorverlustleistung wird aus der Summe der ersten und zweiten modellierten Verlustleistung berechnet.

Die Auftrennung in einen hochfrequenten und einen niederfrequenten Anteil des modellierten Kondensatorstroms kann von der Schaltfrequenz des Wechselrichters des Zwischenkreisumrichters abhängen. Bei Anwendung einer PWM-Steuerung, kann somit die PWM-Schaltfrequenz zur Bestimmung der Grenze zwischen hochfrequentem und niederfrequentem Anteil des modellierten Kondensatorstroms herangezogen werden.

Vorteilhafterweise wird der niederfrequente Anteil des modellierten Kondensatorstroms ermittelt, indem die Kondensatorspannung und/oder eine zeitliche Ableitung der Kondensatorspannung und/oder die der modellierte Kondensatorstrom mittelwertgefiltert wird. Damit werden hochfrequente Anteile abgeschnitten und haben in weiterer Folge keinen Einfluss auf die erste modellierte Verlustleistung. Wenn die Kondensatorspannung mittelwertgefiltert wird, so werden lediglich niederfrequente Anteile der Kondensatorspannung weiter verarbeitet. Nach dem zweiten Zusammenhang, also beispielsweise mittels zeitlicher Ableitung und Multiplikation mit der Ersatzkapazität, wird auf den niederfrequenten Anteil des modellierten Kondensatorstroms geschlossen. Wird jedoch erst der zweite Zusammenhang verwendet, so wird erst der modellierte Kondensatorstrom mit hochfrequenten und niederfrequenten Anteilen berechnet, und danach mittelwertgefiltert, um den hochfrequenten Anteil abzuschneiden und den niederfrequenten Anteil zu erhalten. Hierzu ist jedoch eine sehr hohe Abtastfrequenz vonnöten.

Die Berechnung des niederfrequenten modellierten Kondensatorstroms kann dabei in einer Niederfrequenzeinheit erfolgen, wobei Tiefpass-Filter vor oder nach der Differenziereinheit vorgesehen sind um die Mittelwertfilterung durchzuführen. Weiter dient das Tiefpass-Filter dazu, aliasing-Probleme zu vermeiden und das Signal zu glätten.

Der hochfrequente Anteil des modellierten Kondensatorstroms kann aus einem vom Wechselrichter verursachten Wechselrichterstrom berechnet werden, was vorteilhafterweise in einer Hochfrequenzeinheit durchgeführt wird. Als Wechselrichterstrom ist hier der zwischenkreisseitige Wechselrichterstrom zu betrachten. Der Wechselrichterstrom kann direkt gemessen werden, oder aus den phasenseitigen Phasenströmen des Umrichters, bzw. des Wechselrichters berechnet werden, wobei die Messung von zwei Phasenströmen ausreichen würde, da der dritte Phasenstrom aus den beiden ersten Phasenströmen berechnet werden kann. Sind mehrere Wechselrichter vorhanden, dann kann der hochfrequente Anteil des modellierten Kondensatorstroms aus der Summe der (zwischenkreisseitigen) Wechselrichterströme ermittelt werden.

In weiterer Folge kann das Quadrat des hochfrequenten Anteils des modellierten Kondensatorstroms berechnet werden, indem das Quadrat des arithmetischen Mittelwerts des Wechselrichterstroms und der arithmetische Mittelwert des quadratischen Wechselrichterstroms ermittelt werden und das Quadrat des arithmetischen Mittelwerts des Wechselrichterstroms vom arithmetischen Mittelwert des quadratischen Wechselrichterstroms subtrahiert wird. Zu diesem Zweck kann eine Anzahl Mittelwertbildner vorhanden sein.

Die Bildung des arithmetischen Mittelwerts des Wechselrichterstroms kann zeitdiskret erfolgen, indem der Wechselrichterstrom mit einer ersten Abtastrate in einem ersten Zeitraum abgetastet wird, wobei eine erste Anzahl an Abtastwerten des Wechselrichterstroms erzeugt wird und die Summe der Abtastwerte des Wechselrichterstroms durch die erste Anzahl dividiert wird.

Analog kann die Bildung des arithmetischen Mittelwerts des quadratischen Wechselrichterstroms erfolgen, indem der quadratische Wechselrichterstroms mit einer zweiten Abtastrate in einem zweiten Zeitraum abgetastet wird, wobei eine Zweite Anzahl an Abtastwerten des quadratischen Wechselrichterstroms erzeugt wird und die Summe der Abtastwerte des quadratischen Wechselrichterstroms und durch die zweite Anzahl dividiert wird.

Die ermittelte Kondensatortemperatur kann über die Zeit aufgezeichnet werden, beispielsweise in einer dazu vorgesehenen Speichereinheit.

Die Vorrichtung kann zum Beobachten und Verarbeiten der Kondensatortemperatur, insbesondere ein Abschalten eines Elements, vorzugsweise zumindest eines Teils des Zwischenkreisumrichters bei Überschreiten einer, beispielsweise voreingestellten, Maximaltemperatur verwendet werden. Dies kann dazu dienen, eine Überhitzung des Kondensators zu vermeiden bzw. die Dauer der erhöhten Temperatur zu minimieren.

Es ist weiters eine Aufgabe der gegenständlichen Erfindung, die Restlebensdauer eines Kondensators eines Zwischenkreises eines Zwischenkreisumrichters zu ermitteln. Das wird dadurch gelöst, indem das erfindungsgemäße Verfahren auch zur Ermittlung des zeitlichen Verlaufs der Kondensatortemperatur und weiter zur Ermittlung der Restlebensdauer des Zwischenkreiskondensators aus dem zeitlichen Verlauf der Kondensatortemperatur mittels eines vorgegebenen Zusammenhangs, vorzugsweise über die Arrhenius-Formel verwendet werden.

Bei Anwendung der Arrhenius-Formel wird der zeitliche Verlauf der Kondensatortemperatur herangezogen, es kann auch die Umgebungstemperatur des Zwischenkreiskondensators miteinbezogen werden, wofür ein Temperatursensor verwendet werden kann. Vorteilhaft gegenüber dem Stand der Technik wird somit der Kondensatorstrom und in weiterer Folge die Kondensatorverlustleistung direkt modelliert und nicht lediglich der Gesamtstrom des Zwischenkreisumrichters aus der gesamten Leistungsaufnahme berechnet und für die Bestimmung der Temperatur verwendet.

Die gegenständliche Erfindung wird nachfolgend unter Bezugnahme auf die Figuren 1 bis 6 näher erläutert, die beispielhaft, schematisch und nicht einschränkend vorteilhafte Ausgestaltungen der Erfindung zeigen. Dabei zeigt

Fig.1 ein vereinfachtes Schaltbild eines Zwischenkreisumrichters in Form eines Servoverstärkers

Fig.2 ein Ersatzschaltbild eines Zwischenkreiskondensators

Fig.3 eine Berechnungseinheit mit Modellbaustein

Fig.3a ein thermisches Modell des Zwischenkreiskondensators

Fig.4 ein allgemeines Pulsmuster eines Wechselrichters mit zugehörigen Phasenströmen

Fig.5 einen Aufbau der Berechnungseinheit zur Berechnung der Kondensatortemperatur und der Restlebensdauer

Fig.6 einen Teil der Berechnungseinheit zur Berechnung des hochfrequenten Anteils des modellierten Kondensatorstroms

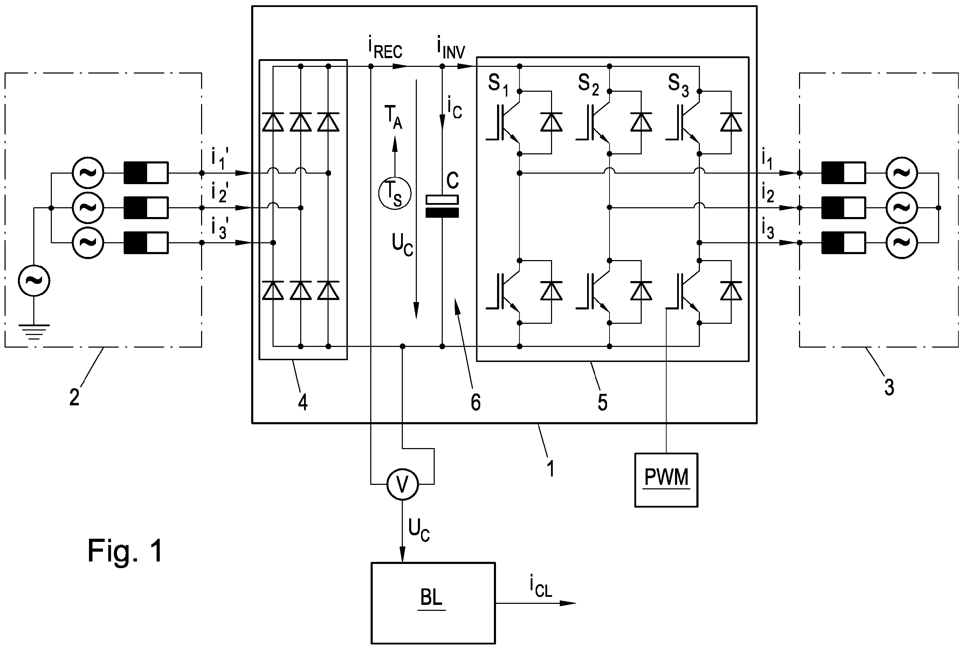

Als beispielhafte Verwendung eines Zwischenkreisumrichters 1 ist in Fig.1 ein vereinfachtes Schaltbild eines Servoverstärkers dargestellt. Der Zwischenkreisumrichter 1 ist eingangsseitig mit dem Versorgungsnetz 2 und ausgangsseitig mit einem Elektromotor 3 verbunden, wobei das Versorgungnetz 2 die Phasenströme $i_1'$, $i_2'$, $i_3'$ an den Zwischenkreisumrichter 1 liefert und der Zwischenkreisumrichter 1 die Wechselrichterströme $i_1$, $i_2$, $i_3$ an den Elektromotor 3 liefert. Die Versorgung des Zwischenkreisumrichters 1 könnte auch durch eine andere Spannungsquelle beispielsweise unter Verwendung von Zwischenkreisklemmen erfolgen. Auf Seite des Versorgungsnetzes 1 ist ein Gleichrichter 4 verbaut, der die eingangsseitige m-phasige Wechselspannung in eine Gleichspannung wandelt, die einen Gleichspannungszwischenkreis 6 (DC-Zwischenkreis) speist. Falls eine Versorgung des Zwischenkreisumrichters über eine andere Spannungsquelle erfolgt, so kann unter Umständen auch kein Gleichrichter 4 vonnöten sein. Ausgangsseitig, auf Seite des Elektromotors 3, ist ein n-phasiger Wechselrichter 5 vorgesehen, der z.B. von einer PWM-Steuerung (aus Zwecken der Übersichtlichkeit nur für einen Leistungsschalter des Wechselrichters 5 dargestellt) angesteuert wird. Die vorliegende Erfindung betrifft Wechselrichter 5 mit einer beliebigen Anzahl n an Phasen, beispielhaft ist ein Wechselrichter mit n=3 Phasen aufgeführt. Es ist in Fig.1 auch das Versorgungsnetz 2 mit m=3 dreiphasig ausgestaltet, so wie der Gleichrichter 4, und der Elektromotor 3, was jedoch nur beispielhaft zu verstehen ist, da die Anzahl der Phasen des Versorgungsnetzes, des Gleichrichters 4 und des Elektromotors 3 nicht übereinstimmen müssen. Der Gleichrichter 4 ist im vorliegenden Beispiel in bekannter Weise für jede der m Phasen als Halbbrücke ausgestaltet und besteht aus zwei Dioden pro Phase. Selbstverständlich könnte der Gleichrichter 4 auch in anderer Ausgestaltung vorliegen, beispielsweise als aktives Front End (AFE) eines Ein/Rückspeisers. Der Wechselrichter 5 ist in ebenfalls bekannter Weise durch Leistungsschalter S, beispielsweise IGBTs oder MOSFETs, realisiert. Als energiespeicherndes Element des DC-Zwischenkreises 6 ist ein Zwischenkreiskondensator C, beispielsweise ein Elektrolytkondensator (ELKO), verbaut. Der Zwischenkreiskondensator C kann dabei schaltungstechnisch natürlich auch als Kombinationsschaltung (Serienschaltung, Parallelschaltung) mehrerer einzelner Zwischenkreiskondensatoren ausgeführt sein. Der Gleichrichter 4 liefert dabei den Gleichrichterstrom $i_{REC}$ und der Wechselrichter 5 entnimmt in Abhängigkeit von der elektrischen Last den Strom $i_{INV}$. Über den Zwischenkreiskondensator C fließt der Kondensatorstrom $i_C$.

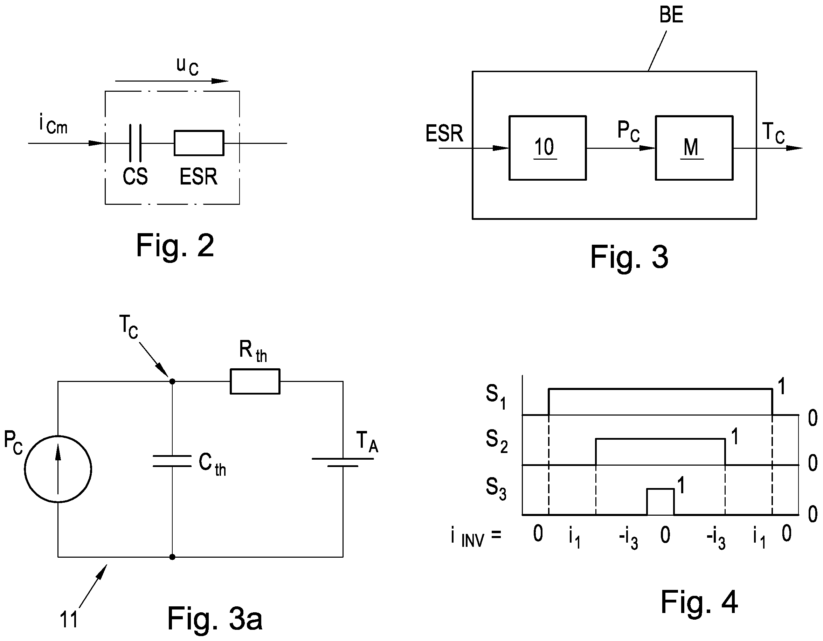

In Fig.2 ist das in der Erfindung verwendete Ersatzschaltbild des Zwischenkreiskondensators C dargestellt. Über eine Ersatzkapazität CS und einen in Serie angenommenen und in der Regel frequenzabhängigen Ersatzwiderstand ESR wird der Zwischenkreiskondensator C modelliert. Über den Ersatzwiderstand ESR, der meist einige Milliohm beträgt und als bekannt angenommen werden kann, fließt der modellierte Kondensatorstrom $i_{Cm}$.

Aus dem modellierten Kondensatorstrom $i_{Cm}$ und dem Wert des Ersatzserienwiderstands ESR wird in einer Berechnungseinheit BE in einer Leistungsberechnungseinheit 10 mittels eines ersten, vorgegebenen Zusammenhangs der Form $P_C = f(i_C, ESR)$, beispielsweise $P_C = i_C{}^2 ESR$, eine modellierte Kondensatorverlustleistung $P_C$ berechnet. Erfindungsgemäß wird weiter aus der modellierten Kondensatorverlustleistung $P_C$ die aktuelle Kondensatortemperatur $T_C$ mittels eines bekannten, in einem Modellbaustein M implementierten Temperaturmodells 11 ermittelt, wie in Fig.3 dargestellt. Ziel ist es somit im ersten Schritt, den Kondensatorstrom $i_C$ durch den modellierten Kondensatorstrom $i_{Cm}$ anzunähern, um die modellierte Kondensatorverlustleistung $P_C$ und dann weiter die davon abhängige Kondensatortemperatur $T_C$ berechnen zu können.

Fig.3a stellt ein mögliches Temperaturmodell 11 des Zwischenkreiskondensators C dar, das es erlaubt die Kondensatortemperatur $T_C$ des Zwischenkreiskondensators C aus der modellierten Kondensatorverlustleistung $P_C$ zu berechnen. Das Temperaturmodell 11 ist hierbei als Modell mit einem Verzögerungsglied 1.Ordnung, ein sogenanntes PT1-Glied, dargestellt, wobei selbstverständlich auch andere Temperaturmodelle verwendet werden können. Im Temperaturmodell 11 stellt die modellierte Kondensatorverlustleistung $P_C$ eine thermische Stromquelle im thermischen Netzwerk dar. Durch eine thermische Kapazität $C_{th}$ und einen thermischen Widerstand $R_{th}$ stellt sich eine thermische Spannung an der thermischen Kapazität $C_{th}$ ein, was der Kondensatortemperatur $T_C$ entspricht. Dazu wird wie in Fig. 1 dargestellt die Umgebungstemperatur $T_A$ des Zwischenkreiskondensators, welche im Temperaturmodell 11 als thermische Spannungsquelle dargestellt wird, mittels des Temperatursensors TS gemessen. Alternativ könnte die Umgebungstemperatur $T_A$ auch durch ein geeignetes Verfahren abgeschätzt werden, beispielsweise aus eine spezifizierten (maximalen) Umgebungstemperatur. Die Umgebungstemperatur $T_A$ und die modellierte Kondensatorverlustleistung $P_C$ werden dem Temperaturmodell 11 zugeführt und daraus die Kondensatortemperatur $T_C$ berechnet.

Der modellierte Kondensatorstrom $i_{Cm}$ kann beispielsweise unter Verwendung der gemessenen Kondensatorspannung $u_C$ und der Ersatzkapazität CS modelliert wird, wobei ein zweiter Zusammenhang der Form $i_C = f(u_C, CS)$, beispielsweise $i_{Cm} = CS \frac{d}{dt} u_C$ verwendet werden kann.

Die zeitliche Ableitung kann beispielsweise in Form einer diskreten Ableitung über einen diskreten Zeitraum $\Delta T$ mit einem Zeitindex k erfolgen:

$$i_{Cm} = CS \frac{d}{dt} u_C = CS \frac{u_{C,k} - u_{C,k-1}}{\Delta T}$$

Dabei entspricht der diskrete Zeitraum $\Delta T$ also der inversen Abtastrate und ist in der Regel weit über der Inversen der PWM-Schaltfrequenz angesiedelt. In Frequenzen ausgedrückt ist die Abtastfrequenz weit unter der PWM-Schaltfrequenz,, womit hochfrequente Anteile des modellierten Kondensatorstroms $i_{Cm}$ unerwünschter Weise abgeschnitten werden würden. Um den modellierten Kondensatorstrom $i_{Cm}$ über diese Methode direkt zu berechnen, wäre daher bei diskreter Ausführung der Ableitung eine Abtastfrequenz als Vielfaches der PWM-Schaltfrequenz vonnöten, was somit eine Abtastfrequenz im MHz-Bereich ergibt. Dies wäre zwar technisch möglich, aber in der Regel aufgrund der notwendigen Bauteile oftmals nicht wirtschaftlich und verursacht außerdem gegebenenfalls weitere Probleme, z.B. Probleme der elektromagnetischen Verträglichkeit (EMV).

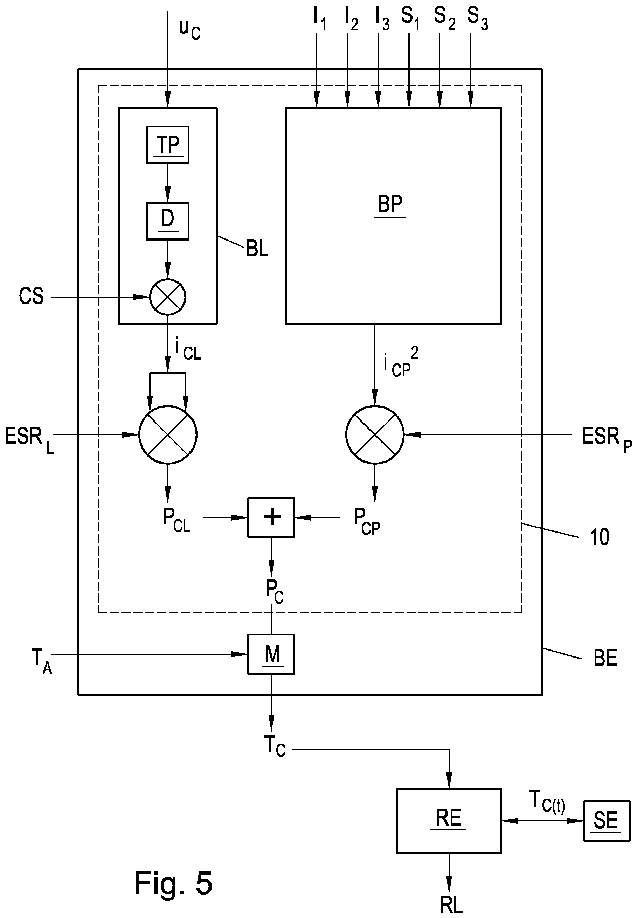

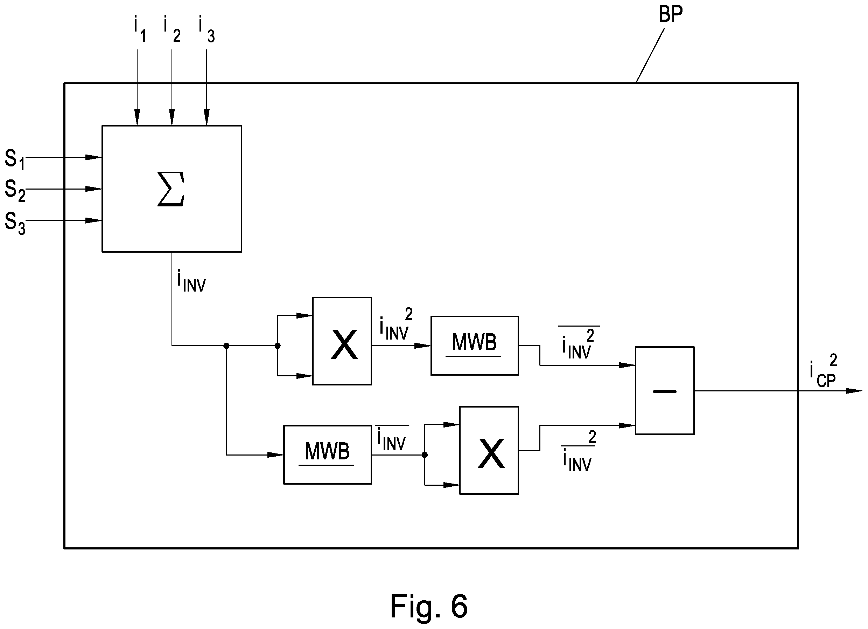

Nachfolgend wird daher anhand der Fig.5 und 6 eine vorteilhafte Ausgestaltung der Ermittlung des modellierten Kondensatorstroms $i_{Cm}$ beschrieben.

Der modellierte Kondensatorstrom $i_{Cm}$ wird vorteilhafterweise in einen niederfrequenten Anteil $i_{CL}$ und einen hochfrequenten Anteil $i_{CP}$ (auch pulsfrequenter Anteil genannt) aufgeteilt, wobei der niederfrequente Anteil $i_{CL}$ des Kondensatorstroms $i_{Cm}$ zur Ermittlung einer ersten Verlustleistung $P_{CL}$ und der hochfrequente Anteil $i_{CP}$ des Kondensatorstroms zur Ermittlung einer zweiten Verlustleistung $P_{CP}$ herangezogen wird. Die Kondensatorverlustleistung $P_C$ wird aus der Summe der ersten Verlustleistung $P_{CL}$ und der zweiten Verlustleistung $P_{CP}$ berechnet.

$$P_C = P_{CL} + P_{CP} = i_C{}^2 ESR = i_{CL}{}^2 ESR_L + i_{CP}{}^2 ESR_P$$

Genau genommen werden die Quadrate des hochfrequenten Anteils $i_{CP}{}^2$ und des niederfrequenten Anteils $i_{CL}{}^2$ des Kondensatorstroms verarbeitet. Das Aufteilen des Quadrats des Kondensatorstroms $i_C{}^2$ in die Summe der Quadrate des niederfrequenten Anteils $i_{CL}{}^2$ und des hochfrequenten Anteils $i_{CP}{}^2$ ist für alle (auch nichtperiodischen) Signale, die in einen Gleichanteil (mittelwertfrei) und in einen Wechselanteil aufgeteilt werden, in dem Intervall, in welchem die Mittelwertbildung erfolgt ist, möglich. Im Falle von Sinusschwingungen wird das Produkt $i_{CL} \cdot i_{CP}$ z.B. über eine Periode integriert und ist aufgrund der Orthogonalität der Sinusschwingungen gleich Null ist. Quantitativ sind die erste Verlustleistung $P_{CL}$ und die zweite Verlustleistung $P_{CP}$ in etwa gleich groß, und der Ersatzserienwiderstand ESR wird auf die Ersatzserienwiderstände $ESR_L$ und $ESR_P$ aufgeteilt, welche wiederum im Vorhinein bekannt sind und beispielsweise aus dem Datenblatt des Zwischenkreiskondensators bezogen werden können.

Eine vorzugsweise in der Berechnungseinheit BE angeordnete Niederfrequenzeinheit BL führt die Berechnung des niederfrequenten Anteils des Kondensatorstroms $i_{CL}$ durch, indem die Kondensatorspannung $u_C$ und/oder die zeitliche Ableitung der Kondensatorspannung $\frac{d}{dt}u_C$ und/oder der modellierte Kondensatorstrom $i_{Cm}$ mittelwertgefiltert wird. Dazu kann, wie in Fig.5 dargestellt, vor einer Differenziereinheit D ein Tiefpass-Filter TP angeordnet sein, um die Kondensatorspannung $u_C$ mittelwertzufiltern. Es wäre natürlich auch (zusätzlich) möglich ein (weiteres) Tiefpass-Filter TP nach der Differenziereinheit D anzubringen, um die zeitliche Ableitung der Kondensatorspannung $\frac{d}{dt}u_C$ mittelwertzufiltern. Ebenso wäre eine Mittelwertfilterung des ermittelten modellierten Kondensatorstroms $i_C$ möglich. Wichtig ist, dass die hochfrequenten Anteile abgeschnitten werden. Die Kondensatorspannung $u_C$ wird wie in Fig. 1 angedeutet mittels eines Spannungsmessers V gemessen und der Niederfrequenzeinheit BL zugeführt. Die Messung der Zwischenkreisspannung, was der Kondensatorspannung $u_C$ entspricht, ist in einem Zwischenkreisumrichter 1 üblicherweise implementiert und stellt damit keinen zusätzlichen Aufwand dar. Der niederfrequente Anteil des modellierten Kondensatorstroms $i_{CL}$ wird nachfolgend quadriert und mit dem niederfrequenten Ersatzwiderstand $ESR_L$ multipliziert, um die erste Verlustleistung $P_{CL}$ zu berechnen.

Die Ursache für den niederfrequenten Anteil des modellierten Kondensatorstroms $i_{CL}$ ist dabei in erster Linie auf Seite des Gleichrichters 4 zu suchen, wobei auch niederfrequente Prozesse wie Laständerungen auf der Seite des Wechselrichters 5 Einflüsse zeigen. Der hochfrequente Anteil des modellierten Kondensatorstroms $i_{CP}$ wird in der Regel durch das hochfrequente Schalten im Wechselrichter 5 verursacht. Im Falle der Anwendung einer PWM-Steuerung entspricht der hochfrequente Frequenzanteil der PWM-Schaltfrequenz und darüber, also meist ab 5kHz. Dementsprechend sind als niederfrequenter Anteil Frequenzen unterhalb der PWM-Schaltfrequenz anzusehen. Da die Kondensatorspannung $u_C$ am Zwischenkreiskondensator C gemessen wird, werden also im Grunde auch niederfrequente Anteile von Seite des Elektromotors 3, und nicht nur sowohl von Seite des Gleichrichters 4, berücksichtigt.

Wird ein Zwischenkreisumrichter 1 vom Versorgungsnetz 1 gespeist (beispielsweise ein 50Hz Dreiphasennetz, wie in Fig. 1 dargestellt), so entsteht nach Gleichrichtung ein Rippel mit einer Frequenz von 300 Hz (Netzrippel, 6 Halbwellen pro Periode). Diesem Rippel überlagert sind die Rückwirkungen des Elektromotors 3 aufgrund des Prozesses, der gerade abgefahren wird (Prozessrippel). Diese Frequenz liegt in der Praxis unter 1000 Hz. Die erste Verlustleistung $P_{CL}$ besteht also aus dem Netzrippel und aus dem Prozessrippel. Durch eine zusätzliche im Gleichrichter angebrachte Drossel könnte dieser Netzrippel reduziert werden, wodurch jedoch Zusatzkosten verursacht werden und erhöhter Platzbedarf auftritt. Wird der Zwischenkreisumrichter 1 anstatt vom Versorgungsnetz 2 durch eine Zwischenkreisklemme mittels einer Gleichspannung versorgt, so entfällt der Netzrippel und für die erste Verlustleistung $P_{CL}$ bleibt nur noch der Anteil des Prozessrippels. Betreibt man den Elektromotor 3 darüber hinaus im sogenannten S1-Modus (d.h. die Last ändert sich nicht), so ergibt sich eine erste Verlustleistung $P_{CL}$ von Null.

Der hochfrequente Anteil des modellierten Kondensatorstroms $i_{CP}$ wird in einer Hochfrequenzeinheit BP, wie anhand von Fig.6 beschrieben, aus dem vom Wechselrichter 5 hervorgerufenen Wechselrichterstrom $i_{INV}$ berechnet. Hierzu wird vorteilhafterweise erst der aus dem Wechselrichter 5 hervorgerufene (zwischenkreisseitige) Wechselrichterstrom $i_{INV}$ als Summe dem Phasenströme $i_1$, $i_2$, $i_3$ des Wechselrichters berechnet.

Für ein allgemeines Pulsmuster der oberen Schalter $S_1$, $S_2$, $S_3$ eines 3-phasigen Wechselrichters 5 ergeben sich die Phasenströme $i_1$, $i_2$, $i_3$ des Wechselrichters 5 laut folgender Tabelle:

| $S_1$ | $S_2$ | $S_3$ | $I_{INV}$ |
|---|---|---|---|
| 0 | 0 | 0 | 0 |
| 0 | 0 | 1 | $i_3$ |
| 0 | 1 | 0 | $i_2$ |
| 0 | 1 | 1 | $-i_1$ |
| 1 | 0 | 0 | $i_1$ |
| 1 | 0 | 1 | $-i_2$ |
| 1 | 1 | 0 | $-i_3$ |
| 1 | 1 | 1 | 0 |

Zur leichteren Veranschaulichung ist das allgemeine Pulsmuster auch in Fig. 4 dargestellt. Besonders vorteilhaft ergibt sich der durch die den Wechselrichter 5 hervorgerufene Wechselrichterstrom $i_{INV}$ aus den gemessenen ersten und zweiten Phasenströmen $i_1$ und $i_2$, wobei der dritte Phasenstrom $i_3$ mittels der ersten Kirchhoff'schen Regel mit $i_3 = -i_1 - i_2$ bestimmt wird, unter Zuhilfenahme des in der Tabelle oben und in Fig. 4 dargestellten Pulsmusters zu

$$i_{INV} = S_1 i_1 + S_2 i_2 + S_3 (-i_1 - i_2)$$

Es könnten natürlich auch alle Phasenstrome $i_1$, $i_2$, $i_3$ oder der Wechselrichterstrom $i_{INV}$ direkt gemessen werden. Die Phasenstrome $i_1$, $i_2$, $i_3$ werden in einem Zwischenkreisumrichter 1 üblicherweise gemessen und sind somit verfügbar. Aus dem Wechselrichterstrom $i_{INV}$ kann der hochfrequente Anteil des modellierten Kondensatorstroms $i_{CP}$ (bzw. das Quadrat des hochfrequenten Anteils $i_{CP}^2$) mit folgendem Verfahren berechnet werden:

Das Quadrat des hochfrequenten Anteils des modellierten Kondensatorstroms $i_{CP}^2$ wird berechnet, indem der arithmetische Mittelwert $\overline{i_{INV}}$ des Wechselrichterstroms $i_{INV}$ (was dem Gleichanteil entspricht) und der arithmetische Mittelwert des quadratischen Wechselrichterstroms $\overline{i_{INV}^2}$ ermittelt werden und das Quadrat des arithmetischen Mittelwerts $\overline{i_{INV}}^2$ vom Mittelwert des quadratischen Wechselrichterstroms $\overline{i_{INV}^2}$ subtrahiert wird.

Die Mittelwertbildung des Wechselrichterstroms erfolgt vorteilhafterweise zeitdiskret. Mit einer ersten Abtastrate $T_{S1}$ ergibt sich in einem ersten Zeitraum $T_1$ eine erste Anzahl $N_1$ an Abtastwerten des Wechselrichterstroms $i_{INV}$. Weiter werden die $N_1$ Abtastwerte des Wechselrichterstroms $i_{INV}$ aufsummiert und durch die erste Anzahl $N_1$ dividiert.

Analog kann einer mit zweiten Abtastrate $T_{S2}$ in einem zweiten Zeitraum $T_2$ eine zweite Anzahl $N_2$ an Abtastwerten des quadratischen Wechselrichterstroms $i_{INV}^2$ zeitdiskret erzeugt werden. Weiter werden die $N_1$ Abtastwerte des quadratischen Wechselrichterstroms $i_{INV}^2$ aufsummiert und durch die zweite Anzahl $N_2$ dividiert.

die Bildung des arithmetischen Mittelwerts des Wechselrichterstroms $\overline{i_{INV}}$ zeitdiskret erfolgt, indem der Wechselrichterstrom $i_{INV}$ mit einer ersten Abtastrate $T_{S1}$ in einem ersten Zeitraum $T_1$ abgetastet wird, wobei eine erste Anzahl $N_1$ an Abtastwerten des Wechselrichterstroms $i_{INV}$ erzeugt wird und die Summe der ersten Anzahl $N_1$ an Abtastwerten des Wechselrichterstroms $i_{INV}$ und durch die erste Anzahl $N_1$ dividiert werden.

In Fig. 5 erfolgen diese Mittelwertbildungen in zwei in der Hochfrequenzeinheit BP befindlichen Mittelwertbildern MWB. Es wäre natürlich auch möglich, dass lediglich ein Mittelwertbilder MWB diese Aufgabe übernimmt, indem er logisch korrekt dem jeweiligen Zweig zugeschaltet wird.

Für die arithmetische Mittelwertbildung erfolgt somit eine Aufsummierung von N Abtastwerten des Wechselrichterstroms $i_{INV}$ im Zeitraum T und eine anschließende Division durch die Anzahl der aufgezeichneten Abtastwerte. Für die Ermittlung des arithmetischen Mittelwert des Quadrats $\overline{i_{INV}^2}$ wird das Quadrat des Wechselrichterstroms $i_{INV}^2$ im Zeitraum T aufsummiert und durch die Anzahl N der aufgezeichneten Abtastwerte dividiert wird.

Das Quadrat des hochfrequenten Anteil des modellierten Kondensatorstroms $i_{CP}$ wird nachfolgend mit dem hochfrequenten Ersatzwiderstand $ESR_P$ multipliziert, um die zweite Verlustleistung $P_{CP}$ zu berechnen. Die erste Verlustleistung $P_{CL}$ und die zweite Verlustleistung $P_{CP}$ werden addiert um die Kondensatorverlustleistung $P_C$ zu erhalten.

Das Temperaturmodell 11 ist in Fig. 5 in einem Modellbaustein M implementiert, dem die Umgebungstemperatur $T_A$ des Zwischenkreiskondensators C und die Kondensatorverlustleistung $P_C$ zugeführt werden. Als Ergebnis wird die Kondensatortemperatur $T_C$ ausgegeben.

In Fig. 5 sind vorteilhafterweise die Niederfrequenzeinheit BL, und die Hochfrequenzeinheit BP, sowie der Modellbaustein M und die Leistungsberechnungseinheit 10 in der Berechnungseinheit BE vorgesehen.

Wie in Fig. 5 dargestellt, kann eine Restlebensdauereinheit RE vorgesehen sein, die die ermittelte Kondensatortemperatur $T_C$ als Kondensatortemperaturverlauf $T_C(t)$ verarbeitet. Dazu werden die in jedem Zeitschritt ermittelten aktuellen Kondensatortemperaturen $T_C$ als zeitlicher Verlauf aufgezeichnet. Dazu kann in einer Speichereinheit SE der Kondensatortemperaturverlauf $T_C(t)$ gespeichert werden. In der Restlebensdauereinheit RE wird mit dem Kondensatortemperaturverlauf $T_C(t)$, unter Zuhilfenahme der bekannten Arrhenius-Formel eine Schätzung der Restlebensdauer RL des Zwischenkreiskondensators C durchgeführt. Die Arrhenius-Formel besagt, dass sich pro ca. 10°C Temperaturverringerung die Restlebensdauer RL des Zwischenkreiskondensators C verdoppelt. Man kann also von der Restlebensdauer RL bei Maximaltemperatur ausgehen und diese auf die aktuelle Kondensatortemperatur $T_C$ umrechnen. Als Beispiel sei eine Gesamtlebensdauer eines Kondensators von 1000 Stunden bei einer maximalen Temperatur von 105°C angenommen. Wird der Zwischenkreiskondensator C immer bei 95°C betrieben, so weist er eine Gesamtlebensdauer von 2000 Stunden auf. Die Gesamtlebensdauer, wie auch die Restlebensdauer RL ist dabei bei einer Angabe in Stunden immer in Bezug auf eine angenommene Kondensatortemperatur $T_C$ zu sehen. Daher ist es hilfreich die Restlebensdauer RL in Prozent anzugeben. Wird oben genannter Zwischenkreiskondensator C für 500 Stunden bei einer Kondensatortemperatur von 95°C betrieben, so bleibt eine Restlebensdauer RL von 1500 Stunden bei 95°C, was einer Restlebensdauer RL von 750 Stunden bei 105°C, oder alternativ dargestellt einer Restlebensdauer RL von 75% entspricht. Wird der Zwischenkreiskondensator C weiter für 100 Stunden bei 105°C betrieben, so reduziert sich die Restlebensdauer RL auf 650 Stunden bei 105°C, bzw. 1300 Stunden bei 95°C, oder auch allgemein auf 65%. Vorteilhafterweise wird nach Erreichen einer vorgegebenen minimalen Restlebensdauer RL eine Aktion durchgeführt. Es kann beispielsweise bei einer Restlebensdauer RL von 20% ein Signal ausgegeben werden, um ein Auswechseln des Zwischenkreiskondensators C zu bewirken.

Es sei ausdrücklich darauf hingewiesen, dass das erfindungsgemäße Verfahren auch auf Zwischenkreisumrichter 1 mit mehreren Wechselrichtern 5 auf der Ausgangsseite verwendet werden kann. Dabei sind an den DC-Zwischenkreis 6 parallel mehrere Wechselrichter 5 angeschlossen. In diesem Fall kann der hochfrequente Anteil des modellierten Kondensatorstroms $i_{CP}$ analog wie oben beschrieben berechnet werden, wobei die Ströme $i_{INVi}$ über die i Wechselrichter 5 zum Strom $i_{INV}$ aufsummiert werden. Diese Summe wird für die weitere Berechnung des arithmetischen Mittelwerts $i_{INV}$ und des Quadrat des Effektivwerts $\overline{i_{INV}^2}$ und in Folge des hochfrequenten Anteils des Kondensatorstroms $I_{CP}$ und schlussendlich des Verlaufs der Kondensatorverlustleistung $P_C$ und der Kondensatortemperatur $T_C$ verwendet.

**Patentansprüche**

1. Verfahren zum Ermitteln einer Kondensatortemperatur ($T_C$) eines Zwischenkreiskondensators (C) eines Zwischenkreisumrichters (1), der mindestens einen n-phasigen Wechselrichter (5) beinhaltet, wobei der Zwischenkreiskondensator (C) als Serienschaltung einer Ersatzkapazität (CS) und eines Ersatzserienwiderstands (ESR) modelliert wird
wobei über den Ersatzserienwiderstand (ESR) ein modellierter Kondensatorstrom ($i_{Cm}$) fließt und **dadurch gekennzeichnet, dass** aus dem modellierten Kondensatorstrom ($i_{Cm}$) und dem Wert des Ersatzserienwiderstands (ESR) mittels eines ersten Zusammenhangs der Form $P_C = f(i_{Cm}, ESR)$ eine modellierte Kondensatorverlustleistung ($P_C$) berechnet wird, aus der mittels eines vorgegebenen Temperaturmodells die Kondensatortemperatur ($T_C$) ermittelt wird.

2. Verfahren nach Anspruch 1, **dadurch gekennzeichnet, dass** der erste Zusammenhang $P_C = i_{Cm}^2$ $P_C$ $ESR$ verwendet wird.

3. Verfahren nach Anspruch 1 oder 2, **dadurch gekennzeichnet, dass** der modellierte Kondensatorstrom ($i_{Cm}$) unter Verwendung einer gemessenen Kondensatorspannung ($u_C$) und der Ersatzkapazität (CS) modelliert wird, wobei ein zweiter Zusammenhang der Form $i_{Cm} = f(u_C, CS)$ verwendet wird.

4. Verfahren nach Anspruch 3, **dadurch gekennzeichnet, dass** der zweite Zusammenhang $i_{Cm} = CS \frac{d}{dt} u_C$ $i_{Cm}$ verwendet wird.

5. Verfahren nach einem der Ansprüche 1 bis 4, **dadurch gekennzeichnet, dass** der modellierte Kondensatorstrom ($i_{Cm}$) in einen niederfrequenten Anteil ($i_{CL}$) und einen hochfrequenten Anteil ($i_{CP}$) aufgeteilt wird, wobei der niederfrequente Anteil des modllierten Kondensatorstroms ($i_{CL}$) zur Ermittlung einer ersten modellierten Verlustleistung ($P_{CL}$) und der hochfrequente Anteil des modellierten Kondensatorstroms ($i_{CP}$) zur Ermittlung einer zweiten modellierten Verlustleistung ($P_{CP}$) herangezogen wird und die modellierte Kondensatorverlustleistung ($P_C$) aus der Summe der ersten modellierten Verlustleistung ($P_{CL}$) und der zweiten modellierten Verlustleistung ($P_{CP}$) berechnet wird.

6. Verfahren nach Anspruch 5, **dadurch gekennzeichnet, dass** der niederfrequente Anteil des modellierten Kondensatorstroms ($i_{CL}$) ermittelt wird, indem die Kondensatorspannung ($u_C$) und/oder eine zeitliche Ableitung der Kondensatorspannung $(\frac{d}{dt} u_C)$ und/oder die der modellierte Kondensatorstrom ($i_{Cm}$) mittelwertgefiltert wird.

7. Verfahren nach Anspruch 5 oder 6, **dadurch gekennzeichnet, dass** der hochfrequente Anteil des modellierten Kondensatorstroms ($i_{CP}$) aus einem vom Wechselrichter (5) verursachten Wechselrichterstrom ($i_{INV}$) berechnet wird.

8. Verfahren nach Anspruch 7, **dadurch gekennzeichnet, dass** das Quadrat des hochfrequenten Anteils des modellierten Kondensatorstroms ($i_{CP}^2$) berechnet wird, indem das Quadrat des arithmetischen Mittelwerts des Wechselrichterstroms ($\overline{i_{INV}}^2$) und der arithmetische Mittelwert des quadratischen Wechselrichterstroms ($\overline{i_{INV}^2}$) ermittelt wer-

den und das Quadrat des arithmetischen Mittelwerts des Wechselrichterstroms ($\overline{i_{INV}}^2$) vom arithmetischen Mittelwert des quadratischen Wechselrichterstroms ($\overline{i_{INV}^2}$) subtrahiert wird.

9. Verfahren nach Anspruch 8, **dadurch gekennzeichnet, dass** die Bildung des arithmetischen Mittelwerts des Wechselrichterstroms ($\overline{i_{INV}}$) zeitdiskret erfolgt, indem der Wechselrichterstrom ($i_{INV}$) mit einer ersten Abtastrate ($T_{S1}$) in einem ersten Zeitraum ($T_1$) abgetastet wird, wobei eine erste Anzahl ($N_1$) an Abtastwerten des Wechselrichterstroms $i_{INV}$) erzeugt wird und die Summe der Abtastwerte des Wechselrichterstroms ($i_{INV}$) und durch die erste Anzahl ($N_1$) dividiert wird.

10. Verfahren nach Anspruch 8, **dadurch gekennzeichnet, dass** die Bildung des arithmetischen Mittelwerts des quadratischen Wechselrichterstroms ($\overline{i_{INV}^2}$) zeitdiskret erfolgt, indem der quadratische Wechselrichterstroms ($i_{INV}^2$) mit einer zweiten Abtastrate ($T_{S2}$) in einem zweiten Zeitraum ($T_2$) abgetastet wird, wobei eine zweite Anzahl ($N_2$) an Abtastwerten des quadratischen Wechselrichterstroms ($i_{INV}^2$) erzeugt wird und die Summe der Abtastwerte des quadratischen Wechselrichterstroms ($i_{INV}^2$) und durch die zweite Anzahl ($N_2$) dividiert wird.

11. Vorrichtung zur Ermittlung der Kondensatortemperatur ($T_C$) eines Zwischenkreiskondensators (C) eines Zwischenkreises (6) eines Zwischenkreisumrichters (1), wobei eine Berechnungseinheit (BE) vorhanden ist, die den Zwischenkreiskondensator (C) als Serienschaltung einer Ersatzkapazität (CS) und eines Ersatzserienwiderstands (ESR) modelliert, wobei über den Ersatzserienwiderstand (ESR) ein modellierter Kondensatorstrom ($i_{Cm}$) fließt und **dadurch gekennzeichnet, dass** die Berechnungseinheit aus dem modellierten Kondensatorstrom ($i_{Cm}$) und dem Wert des Ersatzserienwiderstands (ESR) mittels eines Zusammenhangs der Form $P_C = f(i_{Cm}, ESR)$ eine modellierte Kondensatorverlustleistung ($P_C$) berechnet und daraus mittels eines vorgegebenen Temperaturmodells (M) die Kondensatortemperatur ($T_C$) ermittelt.

12. Vorrichtung nach Anspruch 11, **dadurch gekennzeichnet, dass** eine Differenziereinheit (D) und eine Spannungsmesseinheit (V) vorhanden sind, wobei die Spannungsmesseinheit (V) eine am Zwischenkreiskondensator (C) anliegende Kondensatorspannung ($u_C$) ermittelt und der Differenziereinheit (D) zuführt und die Differenziereinheit (D) den modellierten Kondensatorstrom ($i_{Cm}$) ermittelt.

13. Vorrichtung nach Anspruch 11, **dadurch gekennzeichnet, dass,** eine Niederfrequenzeinheit (BL) vorhanden ist, die ausgestaltet ist einen niederfrequenten Anteil des modellierten Kondensatorstrom ($i_{CL}$) zu berechnen, indem vor und/oder nach der Differenziereinheit (D) eine Anzahl Tiefpass-Filter (TP) vorgesehen sind.

14. Vorrichtung nach einem der Ansprüche 11 bis 13, **dadurch gekennzeichnet, dass** eine Hochfrequenzeinheit (BP) vorhanden ist, die einen hochfrequenten Anteil des modellierten Kondensatorstroms ($i_{CP}$) aus einem vom Wechselrichter (5) verursachten Wechselrichterstrom ($i_{INV}$) berechnet.

15. Vorrichtung nach Anspruch 14, **dadurch gekennzeichnet, dass** eine Anzahl Mittelwertbildner (MWB) vorhanden ist, die einen Mittelwert des Wechselrichterstroms ($\overline{i_{INV}}$), bzw. einen Mittelwert des quadratischen Wechselrichterstroms ($\overline{i_{INV}^2}$) berechnen.

16. Verwendung eines Verfahrens nach einem der Ansprüche 1 bis 9 zum Beobachten und Verarbeiten der Kondensatortemperatur ($T_C$), insbesondere ein Abschalten eines Elements des Zwischenkreisumrichters (1) bei Überschreiten einer Maximaltemperatur.

17. Verwendung eines Verfahrens nach einem der Ansprüche 1 bis 9 zur Ermittlung des zeitlichen Verlaufs der Kondensatortemperatur ($T_C(t)$) und Ermittlung der Restlebensdauer (RL) des Zwischenkreiskondensators (C) aus dem zeitlichen Verlauf der Kondensatortemperatur ($T_C(t)$) mittels eines vorgegebenen Zusammenhangs, vorzugsweise über die Arrhenius-Formel.

**Claims**

1. A method for determining a capacitor temperature ($T_C$) of a link capacitor (C) of a link converter (1), which contains at least one n-phase inverter (5) wherein the link capacitor (C) is modeled as a series interconnection of an

equivalent capacitance (CS) and an equivalent series resistance (ESR), wherein a modeled capacitor current (iCm) flows across the equivalent series resistance (ESR) **and characterized in that that** a modeled capacitor power loss ($P_C$), from which the capacitor temperature ($T_C$) is determined by means of a specified temperature model, is calculated from the modeled capacitor current ($i_{Cm}$) and the value of the equivalent series resistance (ESR) by means of a first relationship of the form $P_C = f(i_{Cm},ESR)$.

2. The method according to claim 1, **characterized in that** the first relationship $P_C = i_{Cm}^2 \; ESR$ is used.

3. The method according to claim 1 or 2, **characterized in that** the modeled capacitor current ($i_{Cm}$) is modeled by using a measured capacitor voltage ($u_C$) and the equivalent capacitance (CS), wherein a second relationship of the form $i_{Cm} = f(u_C,CS)$ is used.

4. The method according to claim 3, **characterized in that** the second relationship $i_{Cm} = CS\dfrac{d}{dt}u_C$ is used.

5. The method according to one of claims 1 to 4, **characterized in that** the modeled capacitor current ($i_{Cm}$) is split into a low-frequency component ($i_{CL}$) and a high-frequency component ($i_{CP}$), wherein the low-frequency component of the modeled capacitor current ($i_{CL}$) is used to determine a first modeled power loss ($P_{CL}$) and the high-frequency component of the modeled capacitor current ($i_{CP}$) is used to determine a second modeled power loss ($P_{CP}$) and the modeled capacitor power loss ($P_C$) is calculated from the sum of the first modeled power loss ($P_{CL}$) and the second modeled power loss ($P_{CP}$).

6. The method according to claim 5, **characterized in that** the low-frequency component of the modeled capacitor current ($i_{CL}$) is determined by mean-filtering the capacitor voltage ($u_C$) and/or a time derivative of the capacitor voltage $\left(\dfrac{d}{dt}u_C\right)$ and/or the modeled capacitor current ($i_{Cm}$).

7. The method according to claim 5 or 6, **characterized in that** the high-frequency component of the modeled capacitor current ($i_{CP}$) is calculated from an inverter current ($i_{INV}$) caused by the inverter (5).

8. The method according to claim 7, **characterized in that** the square of the high-frequency component of the modeled capacitor current ($i_{CP}^2$) is calculated by determining the square of the arithmetic mean of the inverter current ($\overline{i_{INV}}^2$) and the arithmetic mean of the squared inverter current ($\overline{i_{INV}^2}$) and subtracting the square of the arithmetic mean of the inverter current ($\overline{i_{INV}}^2$) from the arithmetic mean of the squared inverter current ($\overline{i_{INV}^2}$).

9. The method according to claim 8, **characterized in that** the arithmetic mean of the inverter current ($\overline{i_{INV}}$) is calculated in a time-discrete manner by sampling the inverter current ($i_{INV}$) at a first sampling rate ($T_{S1}$) in a first time span ($T_1$), wherein a first number ($N_1$) of sample values of the inverter current ($i_{INV}$) is produced and the sum of the sample values of the inverter current ($i_{INV}$) and is divided by the first number ($N_1$).

10. The method according to claim 8, **characterized in that** the arithmetic mean of the squared inverter current ($\overline{i_{INV}^2}$) is calculated in a time-discrete manner by sampling the squared inverter current ($i_{INV}^2$) at a second sampling rate ($T_{S2}$) in a second time span ($T_2$), wherein a second number ($N_2$) of sample values of the squared inverter current ($i_{INV}^2$) is produced and the sum of the sample values of the squared inverter current ($i_{INV}^2$) and is divided by the second number ($N_2$).

11. A device for determining the capacitor temperature ($T_C$) of a link capacitor (C) of a link (6) of a link converter (1), wherein a calculating unit (BE) is present, which models the link capacitor (C) as a series interconnection of an equivalent capacitance (CS) and an equivalent series resistance (ESR), wherein a modeled capacitor current ($i_{Cm}$) flows across the equivalent series resistance (ESR) and **characterized in that** a modeled capacitor power loss ($P_C$) is calculated from the modeled capacitor current ($i_{Cm}$) and the value of the equivalent series resistance (ESR) by means of a relationship of the form $P_C = f(i_{Cm},ESR)$ and the capacitor temperature ($T_C$) is determined therefrom by means of a specified temperature model (M).

12. The device according to claim 11, **characterized in that** a differentiating unit (D) and a voltage-measuring unit (V) are present, wherein the voltage-measuring unit (V) determines a capacitor voltage ($u_C$) present at the link capacitor (C) and feeds said capacitor voltage ($u_C$) to the differentiating unit (D) and the differentiating unit (D) determines the modeled capacitor current ($i_{Cm}$).

13. The device according to claim 11, **characterized in that** a low-frequency unit (BL) is present, which is designed to calculate a low-frequency component of the modeled capacitor current ($i_{CL}$) **in that** a number of low-pass filters (TP) is provided before and/or after the differentiating unit (D).

14. The device according to one of claims 11 to 13, **characterized in that** a high-frequency unit (BP) is present, which calculates a high-frequency component of the modeled capacitor current ($i_{CP}$) from an inverter current ($i_{INV}$) caused by the inverter (5).

15. The device according to claim 14, **characterized in that** a number of mean calculators (MWB) is present, which calculate a mean of the inverter current ($\overline{i_{INV}}$) or a mean of the squared inverter current ($\overline{i_{INV}^2}$).

16. The use of a method according to one of claims 1 to 9 for the monitoring and processing of the capacitor temperature ($T_C$), particularly the switching-off of an element of the link converter (1) when a maximum temperature is exceeded.

17. The use of a method according to one of claims 1 to 9 to determine the temporal progression of the capacitor temperature ($T_C(t)$) and to determine the remaining service life (RL) of the link capacitor(C) from the temporal progression of the capacitor temperature ($T_C(t)$) by means of a specified relationship, preferably by means of the Arrhenius formula.

**Revendications**

1. Procédé de détermination d'une température de condensateur (Tc) d'un condensateur de circuit intermédiaire (C) d'un convertisseur de circuit intermédiaire (1) contenant au moins un onduleur à phase n (5), le condensateur de circuit intermédiaire (C) étant modélisé comme un circuit en série d'une capacité de remplacement (CS) et d'une résistance en série de remplacement (ESR), un courant de condensateur ($i_{Cm}$) modélisé s'écoulant par la résistance en série de remplacement (ESR), **et caractérisé en ce qu'une** perte de puissance de condensateur modélisée ($P_C$) est calculée à partir du courant de condensateur ($i_{Cm}$) modélisé et de la valeur de la résistance en série de remplacement (ESR) au moyen d'un premier rapport de forme $P_C = f(i_{Cm}, ESR)$, perte de puissance à partir de laquelle la température de condensateur ($T_C$) est déterminée au moyen d'un modèle de température prédéterminé.

2. Procédé selon la revendication 1, **caractérisé en ce que** le premier rapport $P_C = i^2_{Cm}\,ESR$ est utilisé.

3. Procédé selon la revendication 1 ou 2, **caractérisé en ce que** le courant de condensateur modélisé ($i_{Cm}$) est modélisé à l'aide d'une tension de condensateur mesurée (uc) et de la capacité de remplacement (CS), un second rapport de forme $i_{Cm} = f(u_C, CS)$ étant utilisé.

4. Procédé selon la revendication 3, **caractérisé en ce que** le second rapport $i_{Cm} = CS\dfrac{d}{dt}u_C$ est utilisé.

5. Procédé selon l'une des revendications 1 à 4, **caractérisé en ce que** le courant de condensateur modélisé ($i_{Cm}$) est divisé en une partie basse fréquence ($i_{CL}$) et une partie haute fréquence ($i_{CP}$), la partie basse fréquence du courant de condensateur modélisé ($i_{CL}$) étant utilisée pour déterminer une première perte de puissance modélisée ($P_{CL}$) et la partie haute fréquence du courant de condensateur modélisé ($i_{CP}$) pour déterminer une seconde perte de puissance modélisée ($P_{CP}$) et la perte de puissance de condensateur modélisée ($P_C$) est calculée à partir de la somme de la première perte de puissance modélisée ($P_{CL}$) et de la seconde perte de puissance de condensateur modélisée ($P_{CP}$).

6. Procédé selon la revendication 5, **caractérisé en ce que** la partie basse fréquence du courant de condensateur modélisé ($i_{CL}$) est déterminée, la tension de condensateur (uc) et/ou une dérivation temporelle de la tension de condensateur $\left(\dfrac{d}{dt}u_C\right)$ et/ou le courant de condensateur modélisé ($i_{Cm}$) étant filtré(e) en une valeur moyenne.

**7.** Procédé selon la revendication 5 ou 6, **caractérisé en ce que** la partie haute fréquence du courant de condensateur modélisé ($i_{CP}$) est calculée à partir d'un courant d'onduleur ($i_{INV}$) provoqué par un onduleur (5).

**8.** Procédé selon la revendication 7, **caractérisé en ce que** le carré de la partie haute fréquence du courant de condensateur modélisé ($i_{CP}^2$) est calculé, le carré de la valeur moyenne arithmétique du courant d'onduleur ($\overline{i_{INV}}^2$) et de la valeur moyenne arithmétique du courant d'onduleur quadratique ($\overline{i_{INV}^2}$) étant déterminés, et le carré de la valeur moyenne arithmétique du courant d'onduleur ($\overline{i_{INV}}^2$) est soustrait de la valeur moyenne arithmétique du courant d'onduleur quadratique ($\overline{i_{INV}^2}$).

**9.** Procédé selon la revendication 8, **caractérisé en ce que** la formation de la valeur moyenne arithmétique du courant d'onduleur ($\overline{i_{INV}}$) intervient de manière discrète dans le temps, le courant d'onduleur ($i_{INV}$) étant balayé à un premier taux de balayage ($T_{S1}$) au cours d'une première période ($T_1$), un premier nombre ($N_1$) de valeurs de balayage du courant d'onduleur $i_{INV}$) étant généré et la somme des valeurs de balayage du courant d'onduleur ($i_{INV}$) étant divisée par le premier nombre ($N_1$).

**10.** Procédé selon la revendication 8, **caractérisé en ce que** la formation de la valeur moyenne arithmétique du carré du courant d'onduleur ($\overline{i_{INV}^2}$) intervient de manière discrète dans le temps, le carré du courant d'onduleur ($i_{INV}^2$) étant balayé à un second taux de balayage ($T_{S2}$) au cours d'une seconde période ($T_2$), un second nombre ($N_2$) de valeurs de balayage du carré du courant d'onduleur ($i_{INV}^2$) étant généré et la somme des valeurs de balayage du carré du courant d'onduleur ($i_{INV}^2$) étant divisée par le second nombre ($N_2$).

**11.** Dispositif de détermination de la température de condensateur ($T_C$) d'un condensateur de circuit intermédiaire (C) d'un circuit intermédiaire (6) d'un convertisseur de circuit intermédiaire (1), une unité de calcul (BE) étant disponible, laquelle modélise le condensateur de circuit intermédiaire (C) comme un circuit en série d'une capacité de remplacement (CS) et d'une résistance en série de remplacement (ESR), un courant de condensateur modélisé ($i_{Cm}$) s'écoulant par la résistance en série de remplacement (ESR), et **caractérisé en ce que** l'unité de calcul calcule, à partir du courant de condensateur modélisé ($i_{Cm}$) et de la valeur de la résistance en série de remplacement (ESR), au moyen d'un rapport de forme $P_C = f(i_{Cm}, ESR)$, une perte de puissance de condensateur modélisée ($P_C$), et détermine ainsi, au moyen d'un modèle de température (M) prédéterminé, la température de condensateur (Tc).

**12.** Dispositif selon la revendication 11, **caractérisé en ce qu'une** unité de différence (D) et une unité de mesure de tension (V) sont disponibles, l'unité de mesure de tension (V) déterminant une tension de condensateur (uc) appliquée au condensateur de circuit intermédiaire (C) et alimentant l'unité de différenciation (D), et l'unité de différenciation (D) détermine le courant de condensateur modélisé ($i_{Cm}$).

**13.** Appareil selon la revendication 11, **caractérisé en ce qu'une** unité basse fréquence (BL) est disponible, laquelle est configurée pour calculer une partie basse fréquence du courant de condensateur modélisé ($i_{CL}$), un nombre de filtres passe-bas (TP) étant prévu avant et/ou après l'unité de différenciation (D).

**14.** Dispositif selon l'une des revendications 11 à 13, **caractérisé en ce qu'**une unité haute fréquence (BP) est prévue, laquelle calcule une partie haute fréquence du courant de condensateur modélisé ($i_{CP}$) à partir d'un courant d'onduleur ($i_{INV}$) provoqué par l'onduleur (5).

**15.** Dispositif selon la revendication 14, **caractérisé en ce qu'**un nombre de générateurs de valeurs moyennes (MWB) est disponible, lequel calcule une valeur moyenne du courant d'onduleur ($\overline{i_{INV}}$) ou une valeur moyenne du courant d'onduleur quadratique ($\overline{i_{INV}^2}$).

**16.** Utilisation d'un procédé selon l'une des revendications 1 à 9 pour observer et traiter la température du condenseur ($T_C$), en particulier pour désactiver un élément du convertisseur de circuit intermédiaire (1) lorsqu'une température maximale est dépassée.

**17.** Utilisation d'un procédé selon l'une des revendications 1 à 9 pour déterminer le profil temporel de la température du condensateur ($T_C(t)$) et déterminer la durée de vie résiduelle (RL) du condensateur de circuit intermédiaire (C) à partir du profil temporel de la température du condensateur ($T_C(t)$) au moyen d'un rapport prédéfini, de préférence par la formule d'Arrhenius.

Fig. 1

Fig. 3

Fig. 2

Fig. 3a

Fig. 4

Fig. 5

Fig. 6

EP 3 199 929 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- KR 20130110553 A

**In der Beschreibung aufgeführte Nicht-Patentliteratur**

- Lifetime of Electrolytic Capacitors in Regenerative Induction Motor Drives. **MADDULA.** Power Electronics Specialists Conference. PESC '05. IEEE, 2005, 153-159